# DEMANDE DE BREVET EUROPEEN

(11) **EP 0 782 227 A1**
(43) Date de publication de la demande: **02.07.1997**
(21) Numéro de dépôt: 96402862.5
(22) Date de dépôt: 23.12.1996
(51) Int. Cl.: H01S 3/085, H01S 3/025, G02B 6/12, G02F 1/025

(54) **Procédé pour intégrer un réseau de Bragg localisé dans un semi-conducteur**

(30) Priorité: 28.12.1995 FR 9515659
(71) Demandeur: Alcatel Optronics, 75008 Paris (FR)
(72) Inventeur: Bodere, Alain, 91680 Bruyeres le Chatel (FR); Carpentier, Danièle, 91000 Evry (FR)
(74) Mandataire: Fournier, Michel

(57) **Abrégé**

Pour réaliser un réseau de Bragg dans un composant semi-conducteur, on effectue une gravure humide à travers un masque de résine révélé après une exposition holographique.

Les régions du réseau situées à la frontière d'autres parties du composant présentent alors des gravures plus profondes.

Pour compenser ce phénomène, le procédé consiste à effectuer une irradiation complémentaire a travers un second masque (E) placé à distance de la partie du masque de résine (7) qui définit la localisation du réseau.

Application aux composants optoélectroniques.

## Description

L'invention se situe dans le domaine des composants optoélectroniques et concerne plus particulièrement les dispositifs comportant au moins un réseau de Bragg localisé, c'est-à-dire dans lesquels il existe au moins une transition entre une région contenant un réseau et au moins une partie voisine sans réseau.

Comme exemple de composants de ce type, on peut citer les lasers à réflecteur de Bragg (DBR) ou les lasers à modulateur intégré (ILM) où la partie laser comporte un réflecteur de Bragg DBR ou une contre-réaction distribuée "DFB".

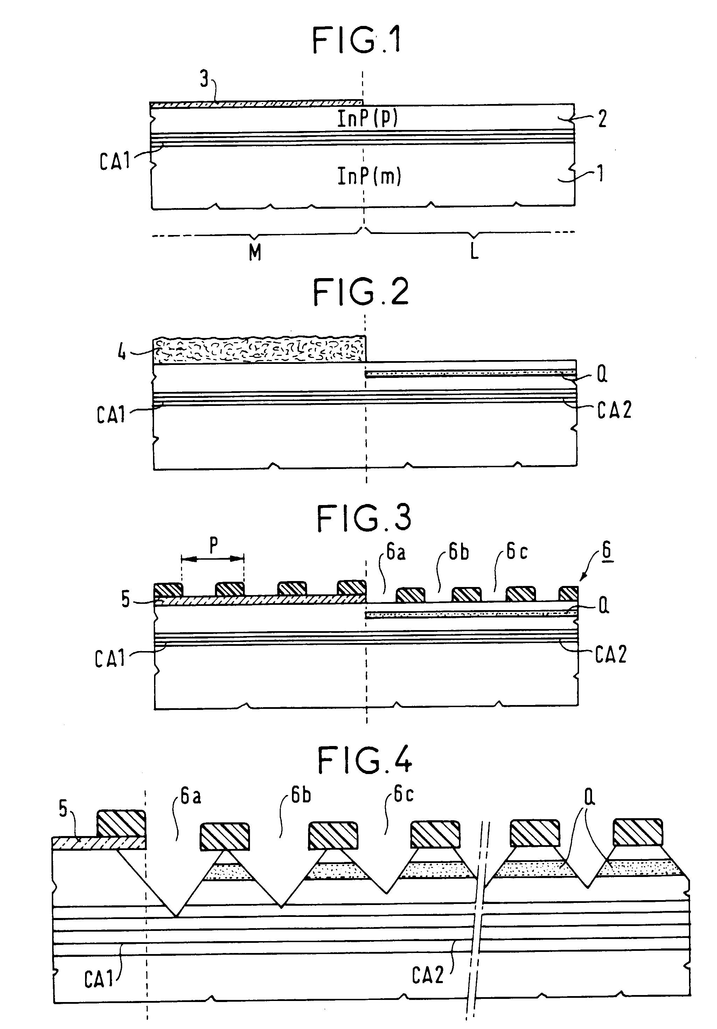

Un procédé classique de fabrication d'un réseau de Bragg localisé est illustré par les figures 1 à 4. Il concerne le cas particulier d'un laser L à modulateur M intégré réalisé sur un substrat de phosphure d'indium InP. Comme représenté à la figure 2, on réalise le réseau en plaçant une couche quaternaire Q au-dessus d'une couche guidante ou active CA2, cette couche quaternaire ayant un indice différent de celui du substrat qui l'entoure. Une des étapes de fabrication du réseau consiste à effectuer une gravure humide de cette couche à travers un masque de résine 6 reproduisant le dessin du réseau à réaliser. Ensuite, après dissolution de la résine, on effectue une croissance de substrat par épitaxie.

Comme il s'agit d'un réseau localisé, les régions du composant ne comportant pas de réseau sont protégées de la gravure. Pour cela, on utilise par exemple une couche de silice 5 déposée sur la surface de la région M à protéger, comme représentée à la figure 3.

La gravure est réalisée par voie humide, c'est-à-dire au moyen d'une solution d'attaque à base de brome par exemple. On constate alors que la profondeur de gravure au travers du masque de résine n'est généralement pas uniforme. Plus précisément, la profondeur est plus importante dans les zones du réseau qui sont à la frontière des régions voisines. Ce phénomène est schématisé à la figure 4.

Ainsi la gravure étant plus rapide dans la zone de transition que sur les autres parties du réseau, on encoure le risque d'attaquer la couche guidante dans cette zone frontière.

L'invention a pour but de remédier à cet inconvénient. Dans ce but, l'invention a pour objet un procédé pour réaliser un réseau de Bragg localisé dans un composant semiconducteur, ledit procédé comportant une étape de gravure humide d'une face du composant à travers un masque de gravure placé sur cette face, ce masque étant formé d'une couche de résine photosensible révélée après une étape d'irradiation holographique définissant le motif dudit réseau, caractérisé en ce que ladite étape d'irradiation holographique est précédée et/ou suivie d'une étape d'irradiation complémentaire de ladite face après avoir placer un second masque à distance de la couche de résine, ledit masque comportant une partie définissant la localisation dudit réseau et en ce qu'au moins celle des faces de ladite partie qui est orientée vers la couche de résine est réfléchissante.

Avantageusement, on prévoira que l'étape d'irradiation holographique est suivie d'une étape de révélation qui précède l'étape d'irradiation complémentaire. Cette disposition présente l'avantage qu'elle permet un contrôle de la qualité du tracé du masque de résine.

D'autres aspects et avantages de l'invention apparaîtront dans la suite de la description en référence aux figures.
- Les figures 1 à 4 illustrent les principales étapes de fabrication d'un réseau de Bragg localisé selon un procédé de l'état de la technique.
- Les figures 5 à 9 illustrent le procédé selon l'invention.

De façon non limitative, l'invention sera exposée dans le cas particulier de la fabrication d'un laser à modulateur intégré réalisé dans un substrat de phosphure d'indium. Comme représenté à la figure 1, le composant est constitué de deux parties : une partie modulateur M et une partie laser L adjacente. La première étape de fabrication consiste à former la couche guidante CA1 du modulateur M par épitaxie sur le substrat 1 de phosphure d'indium dopé n. On fait croître ensuite une couche de confinement supérieure 2 constituée de phosphure d'indium dopé p. La partie modulateur M est alors protégée par un masque de silice 3. La partie laser est ensuite gravée de façon à éliminer la couche guidante CA1 dans cette partie. On fait croître ensuite successivement la couche active CA2 du laser, une couche de confinement supérieure en phosphure d'indium dopé p, une couche quaternaire Q d'indice différent de celui de la couche de confinement supérieure et une nouvelle couche de phosphure d'indium dopé p. Le résultat obtenu est représenté à la figure 2. On peut y voir aussi une couche 4 composée de silice et de polycristal résultant des opérations précédentes. Cette couche 4 doit être retirée et remplacée par un nouveau masque de silice 5 permettant une suite correcte des opérations.

Pour réaliser le masque de résine définissant le motif du réseau, on dépose à la surface du composant une couche de résine photosensible à laquelle on fait subir une exposition holographique. Après révélation, on obtient le masque 6 représenté à la figure 3. Le masque a alors la forme d'une succession d'ouvertures 6a, 6b, 6c régulièrement espacées dont le pas p définira la longueur d'onde du laser..

On effectue ensuite une gravure humide à base de brome de façon à graver la couche quaternaire Q selon le pas P du réseau. Une nouvelle croissance d'InP dopé p permet de réaliser l'alternance d'indice au niveau de la couche quaternaire Q.

Comme représenté à la figure 4, il apparaît que la zone de la partie laser qui se trouve à proximité de la partie modulateur présente une profondeur de gravure bien supérieure à celle des zones éloignées. Ceci entraîne un risque important de dégrader la couche active CA2.

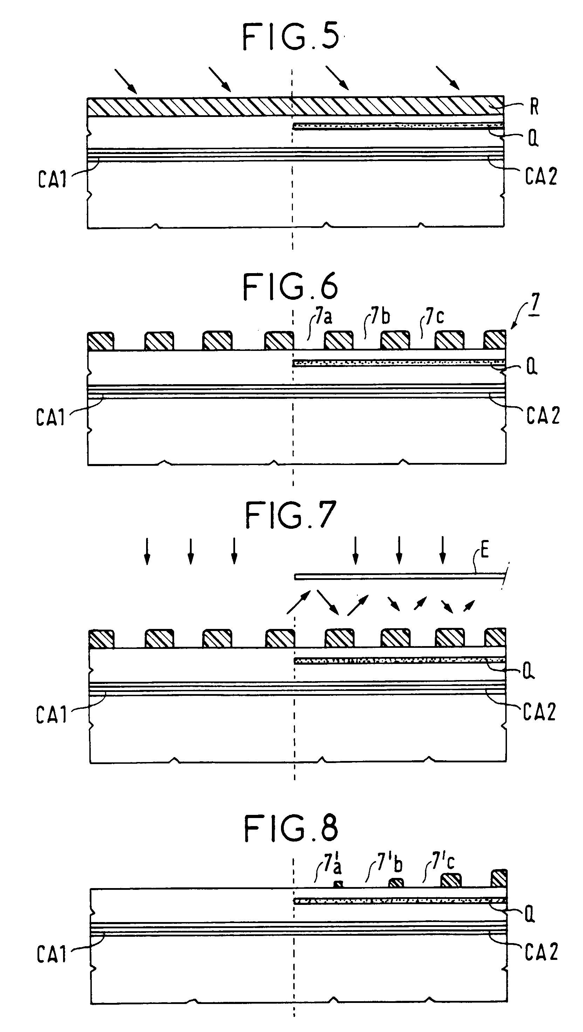

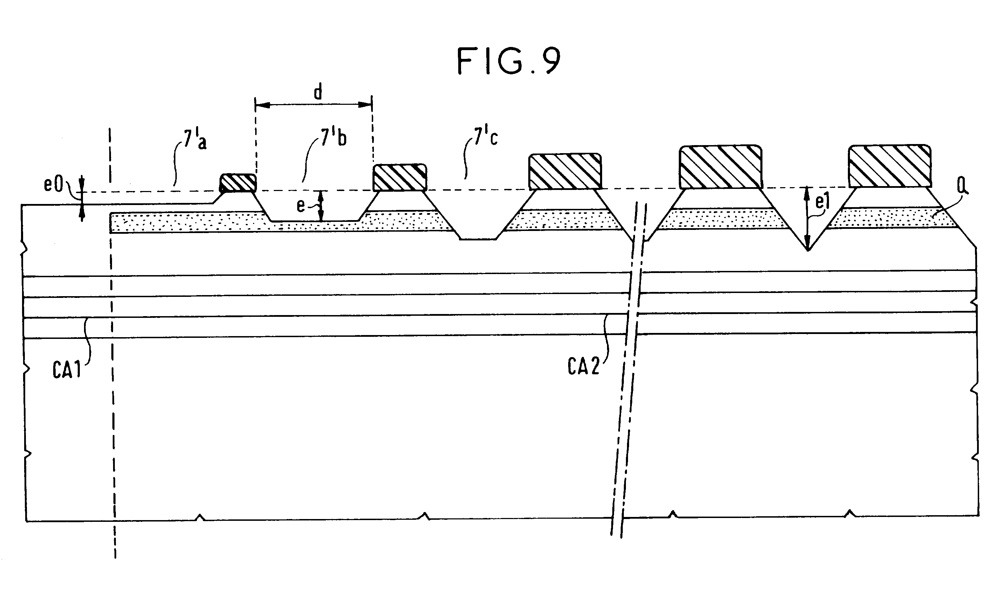

Pour remédier à cette difficulté, l'invention propose de modifier le procédé à partir de l'étape représentée à la figure 2. Comme précédemment, on retire la couche 4 de silice et de polycristal mais on dépose ensuite directement la couche de résine R comme le montre la figure 5. Après exposition holographique et révélation, on obtient le masque de résine 7 représenté à la figure 6. Comme précédemment, les ouvertures dans le masque sont régulièrement espacées et de largeur constante. Ensuite, comme le montre la figure 7, on dispose un second masque à distance de la couche de résine. Ce masque est muni d'une partie E dont au moins celle de ses faces qui est orientée vers la résine est réfléchissante. On expose ensuite la surface du composant à travers ce masque. Comme la partie E a sa face inférieure réfléchissante, la résine située en dessous est partiellement irradiée avec une énergie qui décroît au fur et à mesure que l'on s'éloigne du bord de la partie E.

Après une nouvelle révélation, le masque a l'aspect représenté à la figure 8. Sur la partie modulateur, la résine est entièrement supprimée, tandis que la partie laser présente un masque dont les largeurs d'ouverture 7'a, 7'b, 7'c sont augmentées dans la zone frontière, ces largeurs d'ouverture diminuant au fur et à mesure que l'on s'éloigne de la partie modulateur.

Après avoir procéder à la gravure humide, on obtient un état de gravure représenté schématiquement à la figure 9. On peut alors constater que l'augmentation des largeurs d'ouverture d a eu pour effet de diminuer la profondeur de gravure e, compensant ainsi l'effet de transition. Par contre, dans les régions éloignées de la zone frontière la profondeur e₁ est pratiquement constante. Il est intéressant de noter que ce procédé a aussi pour effet de réaliser une gravure de la partie modulateur sur une faible profondeur e0. Ce phénomène a pour conséquence bénéfique d'améliorer l'état de surface dans cette partie et donc de favoriser une i reprise d'épitaxie ultérieure.

Un résultat analogue serait obtenu si on modifiait l'ordre des deux types d'expositions et si une seule révélation finale était effectuée. De même, l'irradiation complémentaire pourrait être effectuée en partie avant et en partie après l'exposition holographique. Il est néanmoins préférable de procéder d'abord à l'exposition holographique et de révéler immédiatement le masque de façon à pouvoir contrôler le bon déroulement de ces opérations.

Les détails de mise en oeuvre devront bien sûr être adaptés à chaque cas particulier.

Ainsi, l'étape d'irradiation complémentaire devra être définie en puissance et en durée d'exposition en fonction du coefficient de réflexion de la partie E et de sa distance par rapport à la couche de résine. Ces paramètres ne sont toutefois pas critiques car des variations de l'étendue de la zone frontière n'ont que peu d'influence sur le fonctionnement du réseau.

A titre d'exemple, pour obtenir une zone frontière de 5 µm avec un masque réfléchissant en chrome placé à 10 µm de la surface, une énergie d'exposition de 100 mJ/cm² conviendra pour une épaisseur de résine comprise entre 50 et 100 nm.

## Revendications

1. Procédé pour réaliser au moins un réseau de Bragg localisé dans un composant semi-conducteur, ledit procédé comportant une étape de gravure humide d'une face du composant à travers un masque de gravure (6,7) placé sur cette face, ce masque (6,7) étant formé d'une couche de résine photosensible révélée après une étape d'irradiation holographique définissant le motif dudit réseau, caractérisé en ce que ladite étape d'irradiation holographique est précédée et/ou suivie d'une étape d'irradiation complémentaire de ladite face après avoir placer un second masque à distance de la couche de résine, ledit masque comportant une partie (E) définissant la localisation dudit réseau et en ce qu'au moins celle des faces de ladite partie (E) qui est orientée vers la couche de résine est réfléchissante.

2. Procédé selon la revendication 1, caractérisé en ce que ladite étape d'irradiation holographique est suivie d'une étape de révélation qui précède ladite étape d'irradiation complémentaire.

3. Procédé selon l'une des revendications 1 ou 2, caractérisé en ce que ladite face réfléchissante de la partie (E) du second masque est composée de chrome.

4. Procédé selon l'une des revendications 1 à 3, caractérisé en ce que ladite étape d'irradiation complémentaire est définie par une puissance d'irradiation et une durée d'exposition qui sont fonction du coefficient de réflexion de ladite face réfléchissante et de la distance entre ledit second masque et ladite couche de résine.
